# FASCICULE DE BREVET EUROPEEN

(11) **EP 2 216 817 B1**
(45) Date de publication et mention de la délivrance du brevet: **08.01.2014**
(21) Numéro de dépôt: 10151480.0
(22) Date de dépôt: 22.01.2010
(51) Int. Cl.: H01L 27/146

(54) **Capteur d'images à semiconducteur à éclairement par la face arrière**
VON HINTEN BELEUCHTETER HALBLEITER-BILDSENSOR
BACK SIDE ILLUMINATED IMAGE SENSOR

(30) Priorité: 05.02.2009 FR 0950723
(43) Date de publication de la demande: 11.08.2010
(73) Titulaire: STMicroelectronics (Crolles 2) SAS, 38920 Crolles (FR); STMicroelectronics (Grenoble) SAS, 38000 Grenoble (FR)
(72) Inventeur: Roy, François, 38180 Seyssins (FR); Descure, Pierrick, 38330 Saint Ismier (FR)
(74) Mandataire: de Beaumont, Michel

(56) Documents cités:
- EP-A- 1 995 783
- WO-A1-2007/063192
- JP-A- 2005 353 994
- US-A- 4 377 817
- US-A1- 2006 289 911
- US-A1- 2007 052 056
- US-A1- 2007 272 958
- US-A1- 2008 083 940

## Description

### Domaine de l'invention

La présente invention concerne un capteur d'images à semiconducteur à éclairement par la face arrière.

### Exposé de l'art antérieur

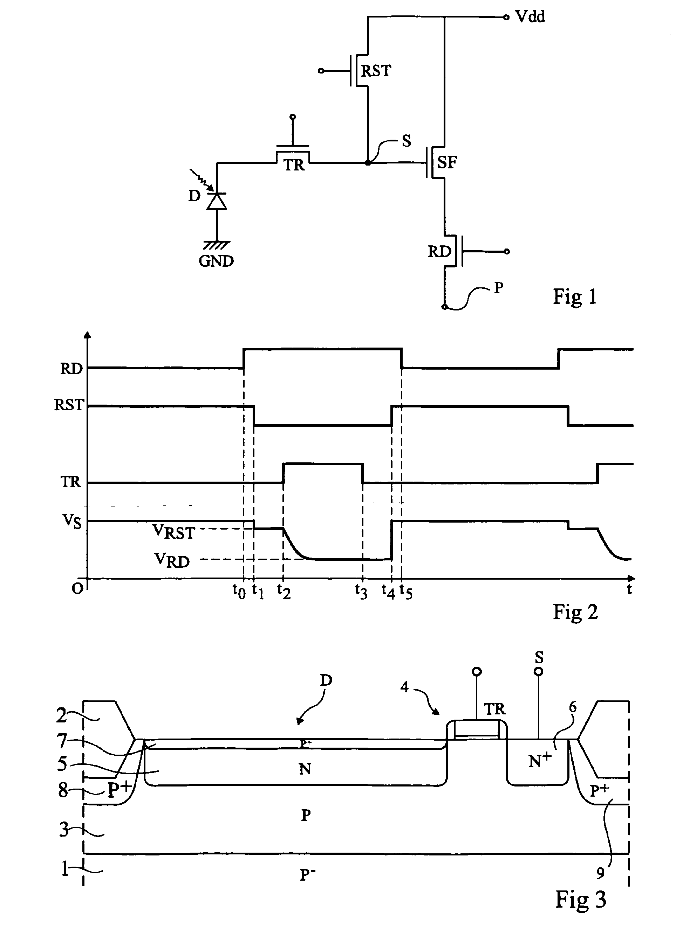

La figure 1 illustre schématiquement le circuit d'une cellule photosensible d'une matrice de cellules photosensibles d'un capteur d'images. A chaque cellule photosensible de la matrice sont associés un transistor de transfert de charges TR, un dispositif de précharge et un dispositif de lecture. Le dispositif de précharge est constitué d'un transistor MOS à canal N RST, interposé entre un rail d'alimentation Vdd et un noeud de lecture S. Le dispositif de lecture est constitué de la connexion en série de premier et second transistors MOS à canal N SF et RD. Le drain du transistor SF est connecté au rail d'alimentation Vdd. La source du transistor RD est connectée à une borne d'entrée P d'un circuit de traitement (non représenté). La grille du transistor de lecture SF, monté en suiveur (source follower), est reliée au noeud de lecture S. La cellule photosensible comprend une photodiode D dont l'anode est reliée au rail d'alimentation de référence GND et la cathode est reliée au noeud S par l'intermédiaire du transistor de transfert de charges TR. De façon générale, les signaux de commande de grille des transistors RD, RST, et TR sont fournis par des circuits de commande non représentés en figure 1 et peuvent être fournis à l'ensemble des cellules photosensibles d'une même rangée de la matrice de cellules. On notera qu'une photodiode est toujours associée à un transistor de transfert TR, mais qu'il peut n'exister qu'un seul dispositif de précharge et un seul dispositif de lecture pour un groupe de photodiodes, les drains des transistors de transfert de ces photodiodes étant alors inter-connectés à un même noeud S.

Des modes de lecture de la cellule photosensible de la figure 1 sont bien connus et on en trouvera un exemple repris ci-après dans le brevet US 7067792 (B5666).

La figure 2 représente un exemple de chronogramme des signaux RD, RST, TR appliqués aux grilles des transistors de même référence et de la tension V_{S} au noeud S du circuit de la figure 1 pour un cycle de lecture. Les signaux RD, RST et TR sont des signaux binaires variant entre des niveaux hauts et bas qui peuvent être différents pour chacun des signaux.

Entre deux cycles de lecture de la cellule photosensible, le signal TR est au niveau bas et le transistor de transfert est bloqué. Un éclairement entraîne la formation et le stockage de charges au niveau de la photodiode D. De plus, le signal RST est à l'état haut. Le transistor de précharge est donc passant. La tension V_{S} est alors sensiblement égale à la tension Vdd.

A un instant t₀, la rangée de la matrice contenant la cellule photosensible à lire est sélectionnée en mettant au niveau haut le signal RD. La précharge du noeud de lecture S est interrompue en mettant à un instant t1 le signal RST à l'état bas, bloquant ainsi le transistor de précharge. La tension V_{S} au noeud de lecture S est alors fixée à un niveau de précharge V_{RST} qui peut être inférieur à la tension Vdd en raison d'un couplage avec le transistor de précharge RST. Le niveau de précharge V_{RST} est généralement perturbé par un bruit provenant essentiellement du bruit thermique du canal du transistor de précharge. Ce bruit est échantillonné et maintenu sur la capacité du noeud S lors du blocage du transistor de précharge. Le niveau de précharge V_{RST} est alors mémorisé à l'extérieur de la cellule photosensible par le circuit de lecture.

A un instant t₂, le signal TR est mis à l'état haut. Le transistor de transfert est alors passant ce qui permet le transfert des charges stockées dans la photodiode D vers le noeud de lecture S. La tension V_{S} diminue alors jusqu'à un niveau de signal utile V_{RD}. Le transfert de charges effectué, le signal TR est mis à un instant t₃ au niveau bas, permettant ainsi d'isoler à nouveau la photodiode D et de recommencer un cycle de formation et de stockage de charges provenant de l'éclairement lumineux. Le niveau de signal utile V_{RD} est alors lu par le circuit de lecture. Comme le niveau de précharge V_{RST}, le niveau de signal utile V_{RD} est perturbé notamment par le bruit thermique du canal du transistor de précharge qui a été échantillonné et maintenu sur la capacité du noeud S. La soustraction des signaux V_{RD} et V_{RST} par le circuit de traitement permet l'élimination du bruit par un double échantillonnage corrélé. La lecture étant achevée, le signal RST est mis à l'état haut à un instant t₄ pour précharger à nouveau le noeud de lecture S. Finalement, à un instant t₅, le signal RD est mis à l'état bas pour désélectionner la cellule photosensible.

La figure 3 illustre, en vue en coupe partielle et schématique, une réalisation sous forme monolithique de l'ensemble de la photodiode D et du transistor de transfert TR de la figure 1. Ces éléments sont réalisés dans une même zone active d'un substrat semiconducteur 1 d'un premier type de conductivité, par exemple de type P, faiblement dopé (P⁻). Ce substrat correspond par exemple à une couche épitaxiée sur une plaquette de silicium qui forme le rail d'alimentation de référence GND. La zone active est délimitée par des zones d'isolement de champ 2 par exemple en oxyde de silicium (SiO₂) et correspond à un caisson 3 de même type de conductivité que le substrat 1 sous-jacent, mais plus fortement dopé. Au-dessus de la surface du caisson 3 est formée une structure de grille isolée 4 éventuellement munie d'espaceurs latéraux. De part et d'autre de la grille 4, à la surface du caisson 3, se trouvent des régions de source 5 et de drain 6 du type de conductivité opposé, par exemple N. La région de drain 6, à droite de la grille 4, est fortement dopée (N⁺). La région de source 5 est réalisée sur une surface beaucoup plus importante que la région de drain 6 et forme avec le caisson 3 sous-jacent la jonction de la photodiode D. La grille 4 et le drain 6 sont solidaires de métallisations (non représentées) qui permettent de mettre en contact ces régions respectivement avec le signal de commande de transfert TR et avec la grille du transistor SF (noeud S), respectivement. La structure est complétée par des régions de type P 8 et 9 fortement dopées (P⁺). Les régions 8 et 9, sous-jacentes aux zones 2, sont connectées au potentiel de référence ou masse par l'intermédiaire du caisson 3 et du substrat 1. La photodiode D est du type dit complètement déplété et comporte, à la surface de sa source 5, une région de type P 7, peu profonde et plus fortement dopée (P⁺) que le caisson 3. Cette région 7 est en contact latéral (vertical) avec la région 8. Elle est donc maintenue en permanence au niveau de tension de référence.

Sur la face supérieure ou face avant de la structure est formé un empilement d'interconnexions. La lumière arrivant sur les photodiodes arrive du côté de l'empilement d'interconnexions et doit passer à travers une succession de couches isolantes de cet empilement tandis que les positions des parties métalliques de l'empilement doivent être sélectionnées pour ne pas gêner la propagation lumineuse. Ceci pose divers problèmes et on a proposé des dispositifs à éclairement par la face arrière (BSI - acronyme du terme anglo-saxon Back Side Illumination) dans lesquels le dispositif est aminci du côté de sa face arrière et utilisé de sorte que la lumière arrive sur les photodiodes à partir de cette face arrière, c'est-à-dire du côté opposé au côté sur lequel l'empilement d'interconnexions est formé. Dans de tels dispositifs BSI, il n'est généralement pas nécessaire d'associer une microlentille à chaque pixel.

Il existe diverses variantes de structures à éclairement par la face avant et à éclairement par la face arrière. Un point commun à beaucoup de ces structures est, comme cela est représenté en figure 3, que le transistor de transfert, occupe une certaine surface de silicium en plus de la surface occupée par les dispositifs de précharge et de lecture. Ainsi, la surface utile de photoconversion est limitée par la surface nécessaire au positionnement du transistor de transfert et des dispositifs de précharge et de lecture. En d'autres termes, pour une surface donnée de cellule, il faut ajouter à la surface occupée par la diode de photoconversion, la surface nécessaire au placement des divers transistors associés à la cellule.

Les documents EP 1 995 783, US 2008/0083940, JP2005353994 et US 2007/0052056 décrivent des capteur d'images à semiconducteur à éclairement par la face arrière.

Un autre problème de certains dispositifs de l'art antérieur réside dans la collection de charges, c'est-à-dire le transfert des charges créées dans la zone de photoconversion vers la surface (généralement la cathode d'une diode) à partir de laquelle ces charges doivent être transférées.

Un autre problème de certains dispositifs de l'art antérieur réside dans l'existence de courants d'obscurité non négligeables.

Un autre problème de certains dispositifs de l'art antérieur réside dans l'impossibilité de stocker des charges en grand nombre lors de chaque période de photoconversion, d'où il résulte notamment des problèmes de saturation.

### Résumé

Un objet de modes de réalisation de la présente invention est de prévoir un dispositif qui pallie un ou plusieurs inconvénients des dispositifs de l'art antérieur.

Un objet de modes de réalisation de la présente invention est de prévoir un capteur d'images qui ait une surface réduite.

Un objet de modes de réalisation de la présente invention est de prévoir un capteur d'images qui présente un faible courant d'obscurité.

Un objet de modes de réalisation de la présente invention est de prévoir un capteur d'images qui optimise la collecte des charges générées dans le photodétecteur.

Un objet de modes de réalisation de la présente invention est de prévoir un capteur d'images qui présente un niveau élevé de stockage de charges.

Un capteur d'images selon l'invention comprend un capteur selon la revendication 1. D'autres modes de réalisation sont définis dans les revendications dépendantes 2 à 5.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, représente un schéma électrique de cellule photosensible ;
la figure 2, précédemment décrite, illustre un chronogramme de tensions caractéristiques du circuit de la figure 1 ;
la figure 3, précédemment décrite, est une vue en coupe partielle et schématique d'une partie du circuit de la figure 1 réalisée sous forme monolithique ;
la figure 4 est une vue en coupe d'un exemple de réalisation d'un capteur d'images ;
la figure 5 est une vue en coupe d'un mode de réalisation d'un capteur d'images selon la présente invention;
les figures 6A et 6B illustrent la distribution de potentiel électrostatique le long d'une ligne A-A pour deux états des dispositifs des figures 4 et 5 ;
la figure 7 est une vue en coupe d'un exemple de réalisation d'un capteur d'images ;
la figure 8 est une vue en coupe illustrant une variante de réalisation d'un capteur d'images selon un autre exemple; et
les figures 9A et 9B illustrent la distribution de potentiel électrostatique le long d'une ligne A-A pour deux états des dispositifs des figures 7 et 8.

### Description détaillée

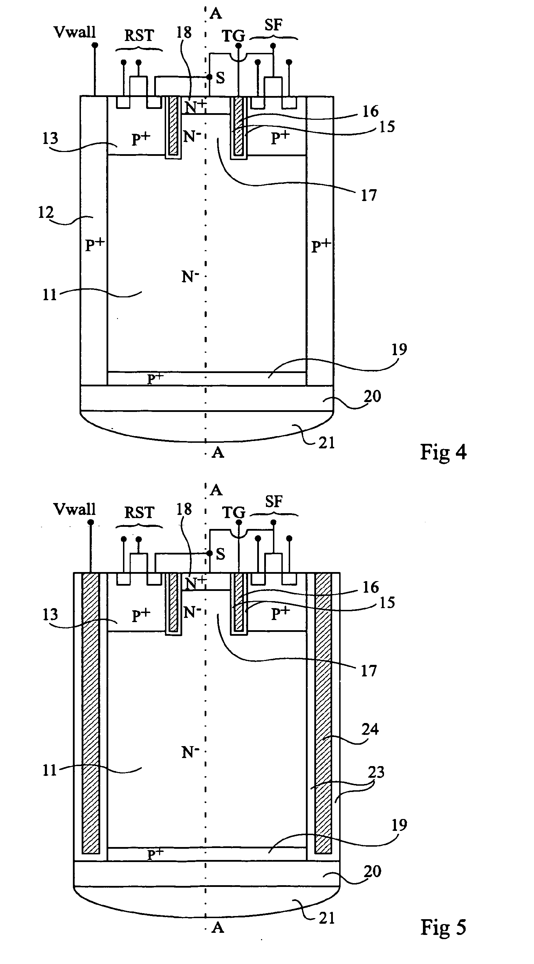

La figure 4 est une vue en coupe d'un exemple de réalisation d'une cellule d'un capteur d'images. Cette cellule est fabriquée à partir d'une portion d'une couche de silicium ou corps 11 faiblement dopé de type N, par exemple à un niveau de dopage de l'ordre de 10¹⁴ à 10¹⁶ atomes/cm³. Cette couche a une épaisseur inférieure à 10 µm, de préférence de l'ordre de 3 à 5 µm. Il s'agit d'un dispositif à éclairement par la face arrière, c'est-à-dire que la couche 11 aura initialement constitué la partie supérieure d'un substrat de silicium épais, éventuellement la couche de silicium supérieure d'une structure de type silicium sur isolant (SOI). Un mur d'isolement fortement dopé de type P 12 entoure la cellule et la sépare des cellules voisines. Un caisson annulaire 13 est formé du côté de la face avant de la cellule et définit une partie sensiblement centrale de type N entourée d'une tranchée isolée (isolant 15) remplie d'un matériau conducteur 16 relié à une borne TG. La partie centrale comprend une partie inférieure faiblement dopée de type N 17 et une partie supérieure fortement dopée de type N 18. Dans le caisson 13 sont formés divers transistors, par exemple les transistors RST et SF de la figure 1 (le transistor RD n'est pas représenté). On rappellera que les transistors de précharge et de lecture peuvent être communs à plusieurs cellules voisines, couramment à un groupe de quatre cellules. Divers niveaux de métallisation sont formés sur la face supérieure, pour assurer les connexions aux drains, sources et grilles des divers transistors. En particulier il est prévu une interconnexion correspondant au noeud de lecture S de la figure 1 entre la région N⁺ 18, le drain du transistor de précharge RST et la grille du transistor suiveur. De façon classique, une fois ces diverses couches et connexions formées, une tranche de silicium formant poignée est collée sur la surface supérieure de l'empilement de métallisations et le dispositif est aminci du côté de la face arrière pour présenter la structure représentée.

Après cela, sur toute la face arrière, on forme une fine couche 19 du deuxième type de conductivité (cette couche peut être réalisée à un autre stade de fabrication, par exemple initialement dans le cas d'un substrat SOI). La couche 19 a une fonction d'inversion du type de porteurs majoritaires contenu dans le corps 11. Cette inversion de la concentration du type de porteurs pourrait aussi être réalisée par une capacité MOS en face arrière munie d'une électrode (métallique, semiconductrice ou diélectrique), transparente dans le spectre de sensibilité utile du capteur, qui crée un canal d'inversion de porteurs libres (effet MOS).

Enfin, la face arrière de chaque cellule est recouverte d'un filtre 20 ayant la couleur désirée pour la cellule considérée, par exemple rouge, vert ou bleu. Eventuellement, bien que cela soit optionnel dans ce type de structure, une lentille 21 recouvre le filtre 20. Comme on l'a indiqué précédemment, la structure semiconductrice peut avoir une épaisseur de l'ordre de 3 à 10 micromètres. En outre, l'étendue latérale de chaque cellule peut être inférieure au micromètre.

La figure 5 est une vue en coupe d'un mode de réalisation d'une cellule d'un capteur d'images. En figure 5 de mêmes éléments sont désignés par de mêmes références qu'en figure 4. La différence principale entre les cellules des figures 5 et 4 est que le mur d'isolement entourant la cellule est constitué d'une tranchée remplie d'un conducteur 24 entouré d'un isolant 23 au lieu d'être une région de type P. Le conducteur 24 est relié à une borne V_{wall}.

Les cellules des figures 4 et 5 fonctionnent de façon similaire. Dans les deux cas, on distingue une phase de photoconversion ou d'intégration au cours de laquelle les faces arrière sont éclairées et des électrons s'accumulent dans le corps 11 et une phase de transfert au cours de laquelle les électrons sont transférés du corps 11 à la couche 18 et au noeud de lecture S.

Pendant la phase d'intégration, la conduction entre le corps semiconducteur 11 et la région fortement dopée de type N 18 est interrompue par action sur la borne de commande TG couplée à la région conductrice isolée 16. En effet, si cette électrode TG est mise à un potentiel négatif, par exemple -1 volt, la région 17 se trouve complètement déplétée en électrons et le passage des porteurs de charge est inhibé par la barrière de potentiel ainsi créée entre la région 17 et la zone de corps 11. Ainsi, la région 17 joue le même rôle que la région de canal du transistor TR des figures 1 et 3 et la région 18 correspond à la région de drain de ce transistor connectée au noeud de lecture S.

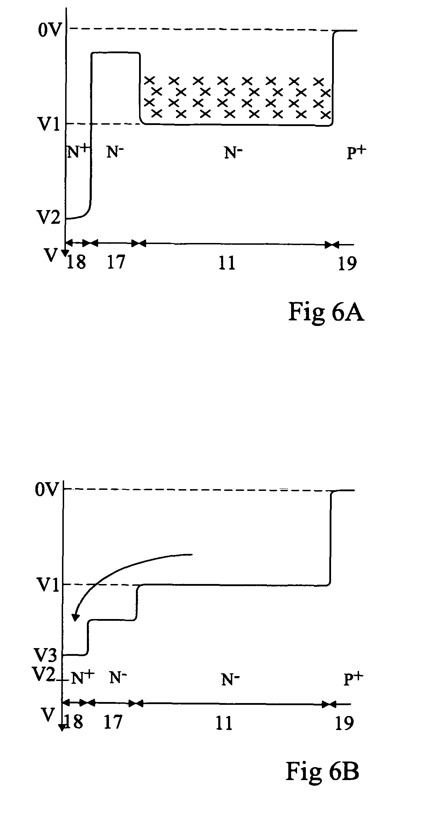

Les figures 6A et 6B représentent la distribution des potentiels électrostatiques pris le long de la ligne A-A des figures 4 et 5, respectivement pendant une phase d'intégration et pendant une phase de transfert.

Comme le représente la figure 6A, pendant une phase d'intégration, le corps 11 correspond à un puits de potentiel dont le potentiel positif maximum V1 décroît progressivement tandis que des électrons (représentés par des croix) s'accumulent dans ce corps. Selon une coupe, non représentée, dans un plan perpendiculaire à l'axe A-A le potentiel électrostatique de la zone de corps 11 est maximum au point d'intersection avec l'axe A-A et diminue tandis que l'on s'éloigne de ce point d'intersection en direction de la paroi isolante 23 du mur d'isolement (figure 5) ou en direction du mur P⁺ 12 (figure 4) qui est au potentiel électrostatique de référence du caisson 13. Le potentiel sur l'électrode 16 est tel que la région centrale 17 est complètement déplétée et que son maximum de potentiel électrostatique est inférieur au maximum de potentiel du corps 11 hors accumulation des charges. Tant que le potentiel électrostatique du corps 11 reste supérieur à celui de la région 17, les électrons ne peuvent pas transiter vers la région 18 à fort niveau de dopage N⁺, cette région 18 étant à un potentiel électrostatique fortement positif V2, proche de Vdd (voir figure 2). Si, par suite de l'accumulation des électrons, le potentiel électrostatique dans le corps atteint le potentiel de la région 17, les électrons en excédent peuvent transiter vers la région 18 et sont évacués dans la zone de drain. Ceci constitue une protection anti-éblouissement (antiblooming). Pendant cette phase d'intégration, dans un exemple de la figure 4 et un mode de réalisation de la figure 5, le mur périphérique est mis à une tension V_{wall} nulle ou faiblement négative pour éliminer les trous. Dans le cas de la figure 4, si le mur P⁺ 12 est au potentiel de la masse, les trous créés dans le corps 11 traverseront la jonction N⁻/P⁺ et seront envoyés vers la connexion de masse V_{wall}. Dans le cas de la figure 5, le potentiel V_{wall} est de préférence légèrement négatif, par exemple -1 volt. Alors, les trous tapisseront la paroi du mur et il s'établira une circulation de trous vers le haut, vers le caisson P⁺ qui se trouve généralement au potentiel de la masse.

Comme le représente la figure 6B, pendant une phase de transfert, un potentiel positif est appliqué à la borne TG. Ainsi, la déplétion de la région N- 17 cesse et les électrons accumulés dans cette région pendant la phase d'intégration sont attirés vers la région N⁺ qui est à un potentiel électrostatique plus élevé que le corps 11. En raison de l'arrivée de ces électrons, le potentiel V_{S} du noeud de lecture S baisse de V2 à V3 et cette variation de potentiel est mesurée par les circuits de lecture et de traitement.

La mise en oeuvre des étapes ci-dessus assure un très bon transfert d'électrons du corps semiconducteur 11 vers la région 18 correspondant au noeud S. Etant donné qu'il n'y pratiquement pas de place perdue pour le corps 11 dans lequel se produit un phénomène de photoconversion, on pourra accumuler des niveaux de charge importants. De plus, la façon dont la périphérie du corps 11 dans lequel se produit la photoconversion est constituée entraîne que l'on a des courants d'obscurité extrêmement bas. En effet, cette périphérie est ou bien complètement entourée de régions P⁺ dans le cas de la figure 4, ou bien entourée partiellement d'une région P⁺ et partiellement d'une structure capacitive à accumulation de trous dans le cas de la figure 5. Enfin, et bien évidemment, le dispositif selon la présente invention permet que pratiquement toute la surface disponible (excepté la surface occupée par les murs d'isolement) soit utilisée pour la photoconversion.

En résumé et de façon imagée, dans le cas des figures 4 et 5, on peut considérer que, pendant la phase d'intégration, on est en présence d'une bouteille dont le corps 11 se remplit progressivement d'électrons tandis que son goulot 17 est fermé et que, pendant la phase de transfert, on ouvre le goulot et on retourne la bouteille pour entraîner les électrons vers la sortie 18 de la bouteille.

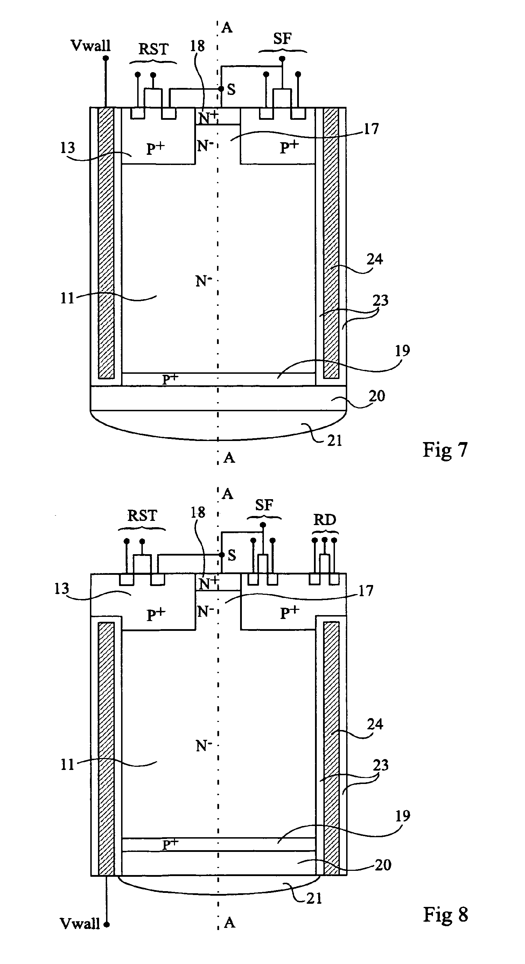

Les figures 7 et 8 représentent deux variantes d'un autre exemple de réalisation. L'exemple de réalisation de la figure 7 est analogue à celui de la figure 5 et de mêmes éléments y ont été désignés par de mêmes références. La différence essentielle est que dans l'exemple de réalisation de la figure 7, la grille 15-16 de fermeture du goulot est absente. Dans cet exemple de réalisation, pendant la phase d'intégration, la borne V_{wall} est mise à une tension fortement positive pour créer un puits de potentiel dans la région de corps 11 et stocker ainsi les électrons à l'intérieur des parois isolantes 23. Dans un plan perpendiculaire à l'axe A-A le potentiel électrostatique de la région de corps 11 est maximum selon l'axe A-A et minimum au niveau des parois isolantes 23. Le potentiel électrostatique de la couche P⁺ 19 est contrôlé par la quantité de trous stockés dans cette zone. Pour un potentiel de couche 19 inférieur au potentiel au niveau des parois 23, il est possible de stocker des trous. Ce déficit de trous sera comblé par apport de trous issus des photocourants. Pour un potentiel de couche 19 tendant à être supérieur au potentiel au niveau des parois il y a un excédent de trous qui sera immédiatement évacué vers le caisson P⁺ 13 via le canal électrostatique au niveau des parois 23. Le potentiel au niveau des parois 23 variant entre le mode d'intégration et le mode de transfert de charges, le potentiel de la couche P⁺ 19 s'ajustera en fonction du cycle et du niveau d'éclairement. La borne V_{wall} est mise à une valeur nulle ou faiblement négative quand on veut effectuer le transfert d'électrons vers la région N⁺ 18 et alors les électrons sont repoussés à travers le goulot vers la région N⁺ 18.

La figure 8 représente une variante de réalisation de la figure 7. Cette fois-ci, le mur latéral entourant le corps semiconducteur 11 est creusé à partir de la face arrière de la structure et non pas comme précédemment à partir de la face avant. Cet exemple de réalisation nécessite des étapes de fabrication différentes mais le résultat obtenu est similaire. L'avantage est que les caissons P⁺ peuvent occuper une plus grande surface étant donné qu'ils s'étendent également au-dessus du mur d'isolement. Pour mieux illustrer cette augmentation de surface des caissons, on a représenté en figure 8 un transistor RD disposé latéralement à côté du transistor SF.

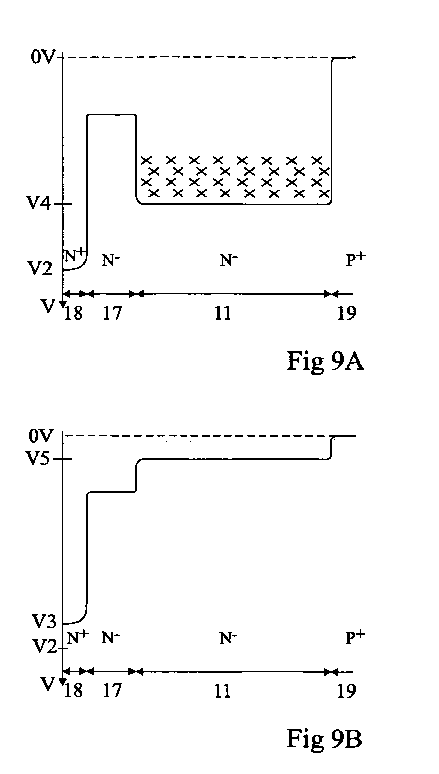

Les figures 9A et 9B représentent la distribution des potentiels électrostatiques le long de la ligne A-A des figures 7 et 8, respectivement pendant une phase d'intégration et pendant une phase de transfert.

Comme le représente la figure 9A, pendant une phase d'intégration, le potentiel du corps 11 est à un potentiel électrostatique élevé (V4) en raison du couplage électrostatique avec le potentiel élevé du mur conducteur isolé périphérique. Ce potentiel est plus élevé que celui de la région centrale 17 (à 0 V ou à un potentiel légèrement positif) et la région 18 se trouve à un potentiel encore plus élevé. Ainsi des électrons (représentés par des croix) s'accumulant dans le corps 11 ne peuvent pas transiter vers la région 18 du fait de la barrière de potentiel constituée par la région 17, sauf si le potentiel de la zone 11 approche la valeur du potentiel de la zone 17. Dans ce cas l'excédent d'électrons est évacué vers la zone de drain 18 N⁺ (antiblooming).

Comme le représente la figure 9B, pendant une phase de transfert, le maximum de potentiel du corps 11 est ramené par couplage électrostatique avec le conducteur isolé du mur d'isolement à une valeur faible (V5), plus faible que celle de la région 17. Ainsi, les électrons débordent au-dessus de la région 17 pour venir s'accumuler au niveau du noeud de lecture, et diminuer son potentiel de V2 à V3.

En reprenant l'image précédente, dans cet exemple de réalisation, pendant la phase de remplissage de la bouteille, bien que le goulot de la bouteille soit ouvert, les électrons sont maintenus contre les parois de la bouteille par attraction électrostatique. Au moment où l'on veut effectuer un transfert, on retourne la bouteille et on appuie sur les parois de sorte que les électrons sont repoussés à travers le goulot vers la sortie 18 de la bouteille.

Le dispositif de saisie d'images fait, par exemple, partie d'un téléphone mobile, d'un appareil photographique numérique, d'une console de jeux portable, ou autre dispositif comprenant un appareil numérique.

On a décrit à titre d'exemple un mode de réalisation dans lequel on détecte, stocke et transfère un signal correspondant à des électrons. L'homme de l'art saura réaliser un système similaire dans lequel les charges sont des trous, en inversant tous les types de conductivité et en adaptant les tensions de mise en oeuvre.

## Revendications

1. Capteur d'images à semiconducteur à éclairement par la face arrière, dans lequel chaque cellule de photodétection comprend un corps semiconducteur (11) d'un premier type de conductivité d'un premier niveau de dopage entouré par un premier mur d'isolement (23, 24), des paires électronstrous étant susceptibles de se former dans ledit corps par suite d'un éclairement par la face arrière,
dans lequel chaque cellule de photodétection comprend, en outre, du côté de la face avant, opposé à la face arrière, dudit corps, un caisson annulaire (13) du deuxième type de conductivité, ce caisson délimitant une région sensiblement centrale (17) dont la partie supérieure (18) est du premier type de conductivité d'un second niveau de dopage supérieur au premier niveau de dopage, et dans lequel
chaque cellule de photodétection comprend, en outre, des moyens (V_{TG} ; V_{wall}) de contrôle du transfert de porteurs de charge dudit corps vers ladite partie supérieure par contrôle électrostatique de ladite région sensiblement centrale **caractérisé en ce que** ces moyens comprennent le premier mur d'isolement constitué d'une tranchée remplie d'un conducteur (24) bordé d'un isolant (23) ayant la profondeur dudit corps, le mur conducteur étant connecté à une borne de polarisation et de commande (V_{wall}),
et un second mur conducteur isolé (15, 16) constitué d'une tranchée remplie d'un conducteur (16) isolé par un isolant (15) ayant la profondeur dudit caisson délimitant ladite région sensiblement centrale (17), ledit second mur étant relié à une borne de commande (V_{TG}).

2. Capteur d'images selon la revendication 1, dans lequel une région (19) dopée du second type de conductivité est formée sur toute la face arrière dudit corps.

3. Capteur d'images selon la revendication 1, dans lequel le premier type de conductivité est le type N et la borne de polarisation et de commande (V_{wall}) est adaptée à être connectée à un potentiel positif pendant une phase de photoconversion et à un potentiel négatif ou nul pendant une phase de transfert.

4. Capteur d'images selon la revendication 1, dans lequel le premier type de conductivité est le type N et la borne de commande (V_{TG}) est adaptée à être connectée à un potentiel négatif pendant une phase de photoconversion et à un potentiel positif ou nul pendant une phase de transfert.

5. Capteur d'images selon la revendication 1, dans lequel le premier type de conductivité est le type N et la borne de commande (V_{TG}) est adaptée à être connectée à un potentiel de niveau bas pendant une phase de photoconversion et à un potentiel de niveau haut pendant une phase de transfert.

## Patentansprüche

1. Halbleiterbildsensor mit rückwärtiger Belichtung, wobei jede Fotodetektionszelle einen Halbleiterkörper (11) eines ersten Leitfähigkeitstyps eines ersten Dotierpegels begrenzt durch eine erste Isolationswand (23, 24) aufweist, wobei sich Elektronen-Loch-Paare mit Wahrscheinlichkeit in dem Körper nach einer rückwärtigen Belichtung bilden;
wobei jede Fotodetektionszelle ferner an der vorderen Oberflächenseite entgegengesetzt zur Rückseite des Körpers eine ringförmige Vertiefung (13) des zweiten Halbleitertyps aufweist, wobei diese Vertiefung eine im Wesentlichen zentrale Region (17) mit ihrem oberen Teil (18) des ersten Leitfähigkeitstyps eines zweiten Dotierniveaus größer als das erste Dotierniveau begrenzt, und wobei jede Fotodetektionszelle ferner Mittel (V_{TG}, V_{wall}) aufweist, um den Transfer der Ladungsträger von dem bewegten Körper zu dem erwähnten oberen Teil durch elektrostatische Steuerung der erwähnten im Wesentlichen zentralen Region zu steuern,
**dadurch gekennzeichnet, dass** die erwähnten Mittel folgendes aufweisen:
eine erste Isolationswand hergestellt aus einem Graben gefüllt mit einem Leiter (24) umgeben mit einem Isolator (23), der die Tiefe des erwähnten Körpers besitzt, wobei die leitende Wand mit einem Vorspann- und Steueranschluss (V_{wall}) verbunden ist, und wobei eine zweite isolierte leitende Wand (15, 16) aus einem Graben gefüllt mit einem Leiter (16) hergestellt ist, und zwar isoliert durch einen Isolator (15) mit der Tiefe der erwähnten Vertiefung, die erwähnte im Wesentlichen zentrale Region (17) begrenzend, wobei die zweite Wand mit einem Steueranschluss (V_{TG}) gekoppelt ist.

2. Der Bildsensor nach Anspruch 1, wobei eine dotierte Region (19) des zweiten Leitfähigkeitstyps über der gesamten hinteren Oberfläche des Körpers gebildet ist.

3. Der Bildsensor nach Anspruch 1, wobei der erste Leitfähigkeitstyp N ist und der Vorspann- und Steueranschluss (V_{wall}) geeignet ist, um mit einer positiven Spannung während der Fotokonversionsphase und einer negativen oder Null-Spannung während einer Transferphase verbunden zu sein.

4. Der Bildsensor nach Anspruch 1, wobei der erste Leitfähigkeitstyp Typ N ist und der Steueranschluss (V_{TG}) geeignet ist, um mit einer negativen Spannung während einer Fotokonversionsphase und mit einer positiven oder Null-Spannung während einer Transferphase verbunden zu sein.

5. Der Bildsensor nach Anspruch 1, wobei der erste Leitfähigkeitstyp Typ N ist und der Steueranschluss (V_{TG}) geeignet ist, um verbunden zu sein mit einer Niedrigpegelspannung, während einer Fotokonversionsphase und mit einer Hochpegelspannung während einer Transferphase.

## Claims

1. A backside illumination semiconductor image sensor, wherein each photodetection cell comprises a semiconductor body (11) of a first conductivity type of a first doping level delimited by a first insulation wall (23, 24), electron-hole pairs being likely to form in said body after a backside illumination;
wherein each photodetection cell further comprises, on the front surface side, opposed to the backside, of said body, a ring-shaped well (13) of the second conductivity type, this well delimiting a substantially central region (17) having its upper portion (18) of the first conductivity type of a second doping level greater than the first doping level, and wherein each photodetection cell further comprises means (V_{TG}, V_{wall}) for controlling the transfer of charge carriers from said body to said upper portion by electrostatic control of said substantially central region,
**characterized in that** said means comprise:
the first insulation wall made of a trench filled with a conductor (24) surrounded with an insulator (23) having the depth of said body, the conductive wall being connected to a bias and control terminal (V_{wall}), and
a second insulated conductive wall (15, 16) made of a trench filled with a conductor (16) insulated by an insulator (15) having the depth of said well delimiting said substantially central region (17), said second wall being coupled to a control terminal (V_{TG}).

2. The image sensor of claim 1, wherein a doped region (19) of the second conductivity type is formed over the entire rear surface of said body.

3. The image sensor of claim 1, wherein the first conductivity type is type N and the bias and control terminal (V_{wall}) is adapted to be connected to a positive voltage during a photoconversion phase and to a negative or zero voltage during a transfer phase.

4. The image sensor of claim 1, wherein the first conductivity type is type N and the control terminal (V_{TG}) is adapted to be connected to a negative voltage during a photoconversion phase and to a positive or zero voltage during a transfer phase.

5. The image sensor of claim 1, wherein the first conductivity type is type N and the control terminal (V_{TG}) is adapted to be connected to a low-level voltage during a photoconversion phase and to a high-level voltage during a transfer phase.
